# EUROPEAN PATENT APPLICATION

(11) **EP 4 730 580 A1**
(43) Date of publication of application: **22.04.2026**
(21) Application number: 24222836.9
(22) Date of filing: 23.12.2024
(51) Int. Cl.: H02B 1/20, H02B 1/28

(54) **DISTRIBUTION BOX WITH LEAKAGE CURRENT LIMITING FUNCTION**

(30) Priority: 21.10.2024 KR 20240143573
(71) Applicant: VISION TECH Corporation, Busan 46257 (KR)
(72) Inventor: Lee, Ho Seok, 48091 Busan (KR)
(74) Representative: Grünecker Patent- und Rechtsanwälte PartG mbB

(57) **Abstract**

The present invention relates to a distribution box (100) with a leakage current limiting function, which includes a conductor enclosure (130) electrically connected to one neutral line of a main breaker (110) or at least one distribution circuit breaker (120) and configured to expand a neutral line area and limit a leakage current, and the conductor enclosure (130) is implemented to be corrosion-resistant to effectively limit the leakage current so that a stable leakage current limiting operation can be secured.

## Description

### CROSS-REFERENCE TO RELATED APPLICATION(S)

This application claims priority from Korean Patent Application No. 10-2024-0143573, filed on October 21, 2024, in the Korean Intellectual Property Office, the disclosure of which is incorporated herein by reference in its entirety.

### BACKGROUND

### 1. Field

The following description relates to leakage current limiting technology, and more particularly, to a distribution box with a leakage current limiting function.

### 2. Description of Related Art

Korean Patent Registration No. 10-1625493 (published on May 30, 2016) filed by the applicant of the present invention describes that a leakage current decreases as a difference in an area ratio between two flat conductors increases. This technology prevents an electric shock by limiting a leakage current using a difference in area of conductive electrodes.

The present inventors studied a distribution box with a leakage current limiting function, which includes a conductor enclosure that is electrically connected to a neutral line (N) of a main breaker or at least one distribution circuit breaker line to expand a neutral line area and limit a leakage current.

### [Related Art Document]

### [Patent Document]

(Patent Document 1) Korean Patent Registration No. 10-1625493 (published on May 30, 2016)

### SUMMARY

This summary is provided to introduce a selection of concepts in a simplified form that are further described below in the Detailed Description. This summary is not intended to identify key features or essential features of the claimed subject matter, nor is it intended to be used as an aid in determining the scope of the claimed subject matter.

The following description relates to providing a distribution box with a leakage current limiting function, which includes a conductor enclosure electrically connected to a neutral line (N) of a main breaker or at least one distribution circuit breaker line to expand a neutral line area and limit a leakage current and implements the conductor enclosure to be robust against corrosion.

In one general aspect, there is provided a distribution box with a leakage current limiting function, which includes a main breaker configured to cut off power distributed from a power line, a plurality of distribution circuit breakers configured to cut off the power distributed from the power line to loads of final ends, a conductor enclosure configured to accommodate the main breaker and the plurality of distribution circuit breakers and electrically connected to a neutral line (N) among lines of the main breaker or at least one distribution circuit breaker to expand a neutral line area and limit a leakage current, and a ground enclosure configured to protect the conductor enclosure from the outside and connected to a ground (G).

According to an additional aspect of the present invention, the conductor enclosure may be made of a conductor including a corrosion-resistant carbon steel or stainless steel material.

According to an additional aspect of the present invention, the distribution box may further include an insulator enclosure disposed between the conductor enclosure and the ground enclosure and configured to electrically insulate the conductor enclosure from the ground enclosure.

Other features and aspects will be apparent from the following detailed description, the drawings, and the claims.

### BRIEF DESCRIPTION OF THE DRAWINGS

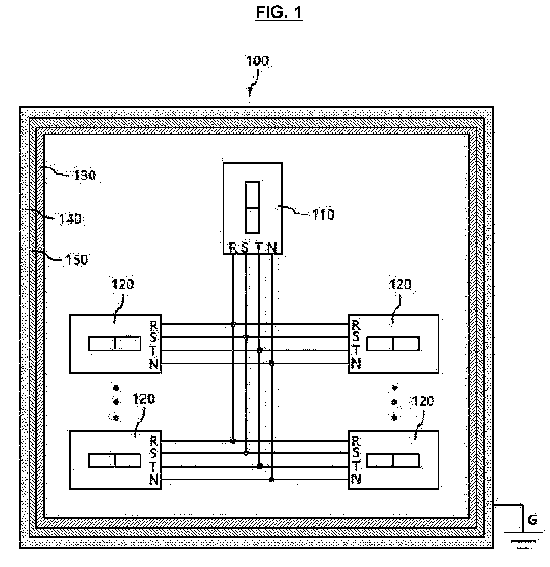

FIG. 1 is a flat cross-sectional view illustrating a configuration of one embodiment of a distribution box with a leakage current limiting function according to the present invention.

Throughout the drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

Hereinafter, the present invention will be described in detail with reference to the attached drawings so that those skilled in the art can easily understand and reproduce the present invention through exemplary embodiments. Although specific embodiments are illustrated in the drawings and detailed descriptions related thereto are provided, this is not intended to limit various embodiments of the present invention to a specific form.

In describing the present invention, when it is determined that a detailed description of a related known function or configuration may unnecessarily obscure the gist of the embodiments of the present invention, the detailed description will be omitted.

When a first component is referred to as being "connected," or "coupled" to a second component, the first component may be directly connected or coupled to the second component, but it should be understood that a third component may be present between the first component and the second component.

Conversely, when a first component is referred to as being "directly connected" or "directly coupled" to a second component, it should be understood that no component may be present between the first component and the second component.

FIG. 1 is a flat cross-sectional view illustrating a configuration of one embodiment of a distribution box with a leakage current limiting function according to the present invention. As shown in FIG. 1, a distribution box 100 with a leakage current limiting function according to the present embodiment includes a main breaker 110, a plurality of distribution circuit breakers 120, a conductor enclosure 130, and a ground enclosure 140.

The main breaker 110 cuts off power distributed from power lines (not shown). In an emergency, when the main breaker 110 is interrupted automatically or manually, supply of power to all loads of a final end (not shown) is cut off.

The plurality of distribution circuit breakers 120 cut off power distributed from the power lines to the loads of the final end. In an emergency, each of the 120 distribution circuit breakers is interrupted automatically or manually, and supply of power to each load at the final end is cut off.

The conductor enclosure 130 accommodates the main breaker 110 and the plurality of distribution circuit breakers 120 and is electrically connected to a neutral line N among lines of the main breaker 110 or at least one distribution circuit breaker 120 to expand a neutral line area and limit a leakage current. For example, the conductor enclosure 130 may be implemented to be electrically connected to the neutral line N among the lines of the main breaker 110 or at least one distribution circuit breaker 120 through a conductor via (not shown), but the present invention is not limited thereto.

An area of the neutral line N becomes larger than areas of high voltage lines R, S, and T among the lines of the main breaker 110 or distribution circuit breaker 120 due to the conductor enclosure 130, and thus an area difference between the high voltage lines R, S, and T and the neutral line N occurs, and the larger the area difference, the smaller the leakage current becomes, and as the leakage current decreases, the risk of electric shock decreases so that a leakage current limiting function that eliminates concerns about an electric shock can be provided.

The reason for this is that, as disclosed in Korean Patent Registration No. 10-1404806 (published on May 30, 2014) as the related art, the leakage current gradually decreases as the area of the flat-shaped conductor connected to a (-) terminal (corresponding to the neutral line of the present invention and the conductor enclosure electrically connected thereto) increases compared to the area of the flat-shaped conductor connected to a (+) terminal of the power source (corresponding to the high voltage line of the present invention).

The ground enclosure 140 protects the conductor enclosure 130 from the outside and is connected to a ground G. In this case, a material of the ground enclosure 140 may be an insulating material such as a plastic or a conductive material such as a metal.

When a ground fault current occurs in the ground enclosure 140, the ground fault current flows through the neutral line N among the lines of the main breaker 110 or at least one distribution circuit breaker 120 line through the ground (G), thereby preventing an electric shock.

In this way, according to the present invention, the distribution box is implemented by including the conductor enclosure that is electrically connected to one neutral line N of the main breaker or at least one distribution circuit breaker line to expand a neutral line area and limit a leakage current so that the leakage current can be efficiently limited.

Meanwhile, according to an additional aspect of the present invention, the conductor enclosure 130 may be made of a conductor including a corrosion-resistant carbon steel or stainless steel material. Carbon steel is an alloy of iron and carbon and is more corrosion-resistant than steel, and stainless steel is a steel alloy that contains chromium and does not corrode itself.

In this way, according to the present invention, the conductor enclosure is made of a conductor including a corrosion-resistant carbon steel or stainless steel material so that a leakage current can be effectively limited through the conductor enclosure and a stable leakage current limiting operation can be secured.

Meanwhile, according to an additional aspect of the present invention, the distribution box 100 with a leakage current limiting function may further include an insulator enclosure 150. The insulator enclosure 150 is disposed between the conductor enclosure 130 and the ground enclosure 140 to electrically insulate the conductor enclosure 130 from the ground enclosure 140.

For example, a material of the insulator enclosure 150 may be an insulating material such as a plastic, and an openable door may be formed on a front surface of the distribution box 100 in a regular hexahedral shape or a rectangular parallelepiped shape formed by sequentially stacking the conductor enclosure 130, the insulator enclosure 150, and the ground enclosure 140 from the inside.

As described above, according to the present invention, the distribution box is implemented by including the conductor enclosure that is electrically connected to one neutral line N of the main breaker or at least one distribution circuit breaker line to expand a neutral line area and limit a leakage current so that the leakage current can be efficiently limited, and the conductor enclosure is implemented to be corrosion-resistant to secure a stable leakage current limiting operation.

According to the present invention, there are the effects of implementing a distribution box to include a conductor enclosure that is electrically connected to one neutral line N of a main breaker or at least one distribution circuit breaker line to expand a neutral line area and limit a leakage current so that the leakage current can be efficiently limited, and implementing a conductor enclosure to be corrosion-resistant to secure a stable leakage current limiting operation.

Various embodiments disclosed in the present specification and the accompanying drawings are merely provided for specific examples so as to aid understanding and are not intended to limit the scope of various embodiments of the present invention.

Accordingly, it should be construed that, in addition to the embodiments described herein, the scope of various embodiments of the present invention falls in the scope of various embodiments of the present invention, and all changes or modified forms derived on the basis of the technical spirit of various embodiments of the present invention are included in the scope of various embodiments of the present invention.

The present invention can be used industrially in a field of technology related to distribution boxes and its application technology field.

## Claims

1. A distribution box with a leakage current limiting function, comprising:
a main breaker configured to cut off power distributed from a power line;
a plurality of distribution circuit breakers configured to cut off the power distributed from the power line to loads of final ends;
a conductor enclosure configured to accommodate the main breaker and the plurality of distribution circuit breakers and electrically connected to a neutral line (N) among lines of the main breaker or at least one distribution circuit breaker to expand a neutral line area and limit a leakage current; and
a ground enclosure configured to protect the conductor enclosure from an outside and connected to a ground (G).

2. The distribution box of claim 1, wherein the conductor enclosure is made of a conductor including a corrosion-resistant carbon steel or stainless steel material.

3. The distribution box of claim 1 or 2, further comprising an insulator enclosure disposed between the conductor enclosure and the ground enclosure and configured to electrically insulate the conductor enclosure from the ground enclosure.
